# EUROPEAN PATENT APPLICATION

(11) **EP 3 001 780 A1**
(43) Date of publication of application: **30.03.2016**
(21) Application number: 15186438.6
(22) Date of filing: 23.09.2015
(51) Int. Cl.: H05K 1/02, H05K 3/00

(54) **FORMABLE LIGHT SOURCE AND METHOD OF MAKING**

(30) Priority: 23.09.2014 US 201462054325 P; 23.09.2014 US 201462054323 P; 03.09.2015 US 201514844796
(71) Applicant: Osram Sylvania Inc., Danvers, MA 01923 (US)
(72) Inventor: GROSSMAN, Kenneth, Beverly, MA Massachusetts 01915 (US); SPEER, Richard S., Concord, MA Massachusetts 01742 (US); PEREYRA, Rodrigo M., Salem, MA Massachusetts 01970 (US)
(74) Representative: Viering, Jentschura & Partner mbB Patent- und Rechtsanwälte

(57) **Abstract**

A method of manufacturing a curved component of a lamp or luminaire comprising forming a sheet segment into a curved portion after forming an electrically conductive trace on the sheet segment and after placing a plurality of LEDs on the sheet segment is described. A luminaire provided by the method of manufacturing is also described herein.

## Description

### CROSS-REFERENCE TO RELATED APPLICATIONS

This patent application claims the benefit of: U.S. Provisional Patent Application No. 62/054323 (Attorney Docket No. 2014P01007US), titled "FORMABLE LIGHT SOURCE AND METHOD OF MAKING," filed on September 23, 2014; U.S. Provisional Patent Application No. 62/054325 (Attorney Docket No. 2014P01197US), titled "FORMABLE LIGHT SOURCE AND METHOD OF MAKING," filed on September 23, 2014; and U.S. Utility Patent Application No. 14844796 (Attorney Docket No. 2014P01661US), titled "THERMOFORMING A SUBSTRATE BEARING LEDS INTO A CURVED BULB ENCLOSURE," filed on September 5, 2015. Each of these patent applications is herein incorporated by reference in its entirety.

### FIELD OF THE DISCLOSURE

The present application generally relates to moldable light source, and more specifically to techniques for use with moldable polymer within the light source.

### BACKGROUND

A conventional incandescent lamp comprises a glass bulb enclosure joined to a lamp base, with a light emitting structure including a filament extending from the base into the interior volume of the bulb enclosure.

In order to save energy, as well as increase lighting performance, many incandescent lamps are being replaced by solid state lighting devices, particularly solid state lighting devices comprising light-emitting diodes (LEDs).

It is known to provide a lamp having LED's mounted on a bent printed circuit board (PCB), and then covering the LEDs and the PCB with a separate bulb enclosure. See, for example, U.S. Pat. 7,086,767 (Sidwell). In this instance, the LED substrate, i.e. printed circuit board, and bulb enclosure may be understood as being two distinct members, which adds complexity, weight and cost to a lamp.

The following illumination devices are also known: U.S. Pat. 5,585,783 (Hall); U.S. Pat. 5,838,247 (Bladowski); U.S. Pat. 5,960,942 (Thorton); U.S. Pat. 6,580,228 (Chen); U.S. Pat. 6,709,132 (Ishibashi); U.S. Pat. 7,086,756 (Maxik); U.S. Pat. 8,314,566 (Steele); U.S. Pat. 8,860,289 (Carroll); U.S. Pat. 8,883,287 (Boyce); U.S. Pat. App. Pub. 2005/0174769 (Yong) and U.S. Pat. App. Pub. 2014/0292176 (Athalye).

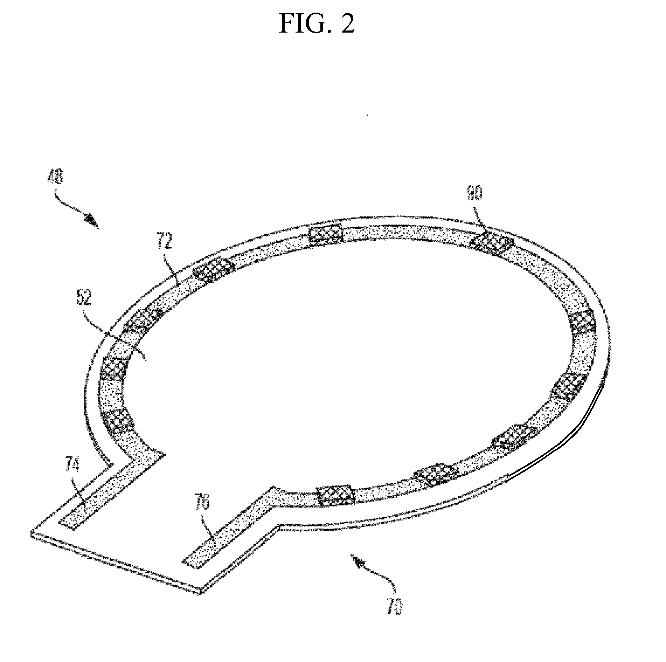

U.S. Pat. 7,862,220 (Cannon) discloses, at col. 5 ln. 45- col. 6, ln. 5, a molded backlit dome light (Figs. 2a-d) in which LEDs 24 having wiring harness 22 are present on a peripheral annular border 21 of printed device 20a within whose interior region a diffusor is present and which interior diffusor region is vacuum molded (Fig. 2b) into a dome region whereas the LEDs and wiring appear to remain planar since border 21 is further integrated into a rigid bezel by its being overmolded with plastic introduced through anchoring holes 26.

U.S. Pat. 7,736,020 (Baroky) discloses a method of making a bulbous substrate to whose exterior surface the LEDs 102 are mounted only after having formed the bulbous substrate.

### BRIEF DESCRIPTION OF THE DRAWINGS

Reference should be made to the following detailed description, read in conjunction with the following figures, wherein like numerals represent like parts:
FIG. 1 shows a perspective view of one sheet segment provided with electrically conductive traces and LEDs located thereon, to be used to provide a curved component of a lamp or luminaire;
FIG. 2 shows a perspective view of one sheet segment provided by a single sheet of plastics material, with electrically conductive traces and LEDs located thereon, to be used to provide the curved component of a lamp or luminaire;
FIG. 3 is an enlarged side view of a prior art LED shown in FIG. 1 or FIG. 2;
FIG. 4 shows a perspective view of a male forming mold which may be used to form the sheet segment of FIG. 1 or FIG. 2 into curved portions of the curved component of a lamp or luminaire;
FIG. 5 shows a side view of a sheet segment of FIG. 1 and the male forming mold of FIG. 4 before the sheet segment is formed into a curved portion of the curved component of a lamp or luminaire;
FIG. 6 shows a side view of a sheet segment of FIG. 2 and the male forming mold of FIG. 5 after the sheet segment is formed into a curved portion of the curved component of a lamp or luminaire;
FIG. 7 shows a perspective view of a female forming mold which may be used to form the sheet segment of FIG. 1 or FIG. 2 into curved portions of the curved component of a lamp or luminaire;
FIG. 8 shows a side view of an outer contour of the sheet segment after being formed into curved portions used to form the curved component of a lamp or luminaire;
FIG. 9 shows a perspective view of an alternative electrically conductive trace of a sheet segment of FIG 1.
Figure 10 is a PET and copper ribbon structure used in the curved component of a lamp or luminaire in accordance with an exemplary embodiment of the present disclosure.
Figure 11 is the curved component of a lamp or luminaire prior to being formed in accordance with an exemplary embodiment of the present disclosure.
Figures 12A and 12B are ABS sheet with LED packages facing inward providing the curved component of a lamp or luminaire in accordance with an embodiment of the present disclosure.
Figure 13A and 13B are ABS sheet with LED packages facing outward providing the curved component of a lamp or luminaire in accordance with an embodiment of the present disclosure.

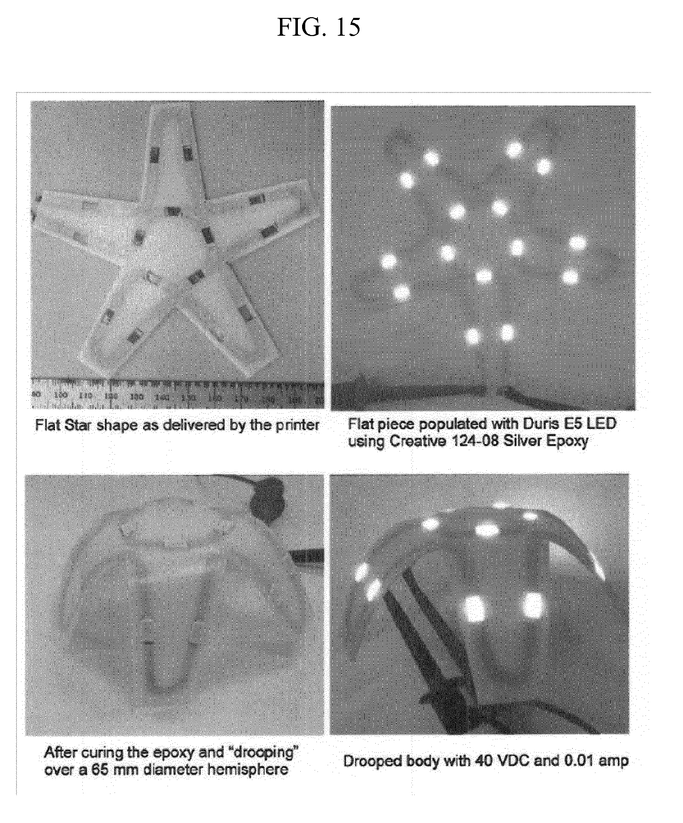

Figures 14 and 15 is a spherical sheet providing the curved component of a lamp or luminaire in accordance with an embodiment of the present disclosure.

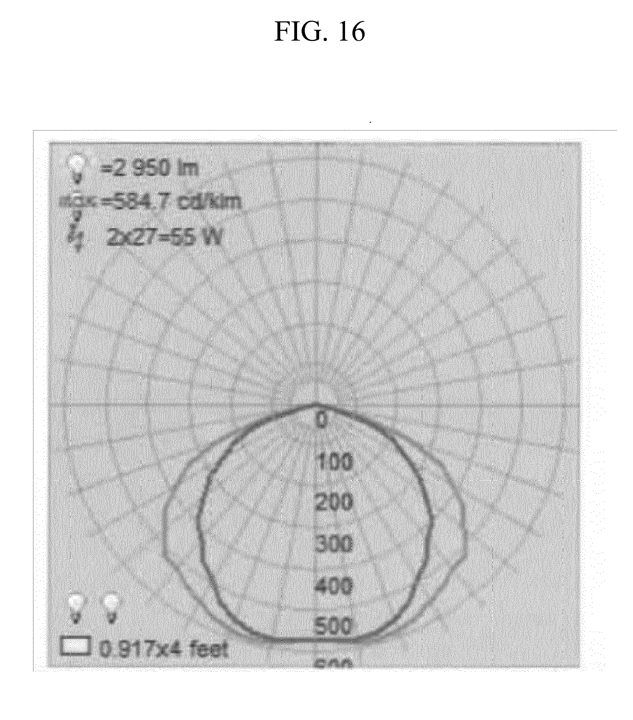

Figure 16 is a linear fluorescent luminaire and a typical light distribution curve for a linear fluorescent luminaire.
Figure 17 is a typical light distribution curve is for a T8 luminaire.
Figure 18A is a PET based sheet having thermoforming without traces and with traces in accordance with an embodiment of the present disclosure.
Figure 18B is a PET based sheet with LEDs in accordance with an embodiment of the present disclosure.
Figure 19 is a CAD model of a luminaire in accordance with an embodiment of the present disclosure.
Figure 20 is a ray tracing simulation of the luminaire in accordance with an embodiment of the present disclosure.
Figure 21a is an aluminum frame and lining the interior of the frame with PET material providing the curved component of a lamp or luminaire in accordance with an embodiment of the present disclosure.
Figure 21b is far field distribution data of the aluminum frame and lining the interior of the frame with PET material providing the curved component of a lamp or luminaire in accordance with an embodiment of the present disclosure.
Figure 22a is a CAD model of a curved component of a lamp or luminaire in accordance with an embodiment of the present disclosure.
Figure 22b is a ray tracing simulation of a curved component of a lamp or luminaire in accordance with an embodiment of the present disclosure.
Figure 23 an area array of LEDs can be placed in the middle of the PET substrate with the additional material formed around it in accordance with an embodiment of the present disclosure.
Figure 24 a LED board can be placed in a heat-sink material in accordance with an embodiment of the present disclosure.
Figure 25 an exemplary luminaire manufacturing process providing the curved component of a lamp or luminaire in accordance with an embodiment of the present disclosure.

These and other features of the present embodiments will be understood better by reading the following detailed description, taken together with the figures herein described. The accompanying drawings are not intended to be drawn to scale. In the drawings, each identical or nearly identical component that is illustrated in various figures may be represented by a like numeral. For purposes of clarity, not every component may be labeled in every drawing.

### DETAILED DESCRIPTION

For a thorough understanding of the present disclosure, reference is made to the following detailed description, including the appended claims, in connection with the above-described drawings. Although the present disclosure is described in connection with exemplary embodiments, the disclosure is not intended to be limited to the specific forms set forth herein. It is understood that various omissions and substitutions of equivalents are contemplated as circumstances may suggest or render expedient. Also, it should be understood that the phraseology and terminology used herein is for the purpose of description and should not be regarded as limiting.

The present disclosure provides solid-state lighting devices particularly in form of a curved component of a lamp or luminaire, and more particularly, methods of manufacturing the curved component of a lamp or luminaire.

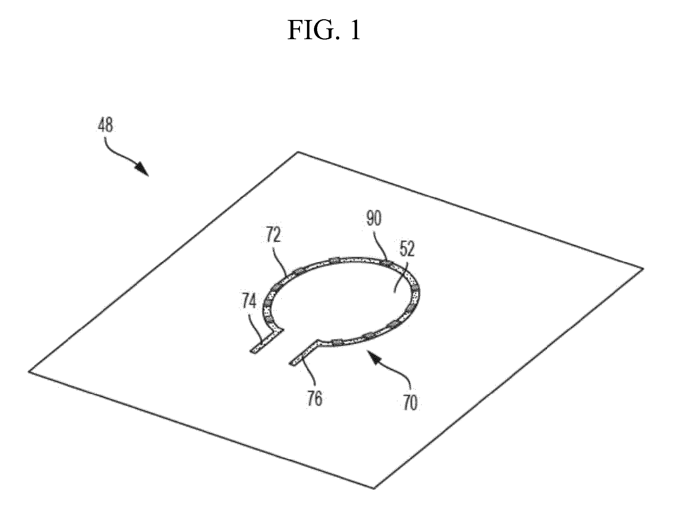

With particular reference to FIGS. 1-2, a curved portion 110 is formed from at a sheet segment 48. Each sheet segment 48 is formed of a plastics material which is electrically non-conductive.

The sheet segment 48 may be formed from a roll of sheetstock which is formed by extrusion, and thus an extrudate. Sheet segment 48 may be formed of the same plastics material composition, which may comprise one or more polymers, particularly one or more thermoplastic polymers. The one or more thermoplastic polymers may each be, for example, Acrylonitrile Butadiene Styrene (ABS), thermoplastic homopolymers, copolymers and/or terpolymers.

Sheet segment 48 may be particularly formed of polyester, particularly polyethylene terephthalate, also referred to as poly(ethylene terephthalate) or simply by the acronym PET. PET is a copolymer of ethylene glycol and one or more dimethyl terephthalates or terephthalic acids. Preferably, sheet segment 48 and second sheet segment 50 each comprise at least 80% by weight PET, and more particularly at least 90% PET.

The sheet segment 48 may comprise one or more layers of plastics material, and have an overall thickness in a range of 0.125 mm to 1.5 mm.

In FIGS. 1-2, the sheet segment 48 is shown in planar form after being taken from a roll of sheetstock and prior to being shaped into a curved portion 110. FIG. 1 shows that sheet segment 48 may be initially in a form sheets of plastics material. Alternatively, as shown in FIG. 2, the sheet segment 48 may be a segment of a single piece of plastics material.

The sheet segment 48 provides a flexible (bendable/stretchable) substrate onto which one or more electrically conductive traces 70 may be formed thereon which provide part of an electrical circuit to light the curved portion 110. As shown, electrically conductive trace 70 is formed on the outer surface 52 of the sheet segment 48. There is at least one electrically conductive trace on the sheet segment 48.

Each electrically conductive trace 70 is formed of an electrically conductive material. For example, each trace 70 may also be formed of (comprising, consisting essentially of or consisting of) an electrically conductive plastics material, such as by laminating, screen printing or three-dimensional printing, or an electrically conductive metal, such as copper by etching.

The electrically conductive plastics material may comprise electrically conductive particles (e.g. metal, carbon black) disposed in a polymer matrix. The polymer matrix may comprise one or more polymers which may be electrically non-conductive or electrically conductive, in which case the electrically conductive particles may be eliminated. The polymer matrix may be selected from one or more polymers which exhibit good bonding properties to the plastics material of the sheet segment 48.

As shown, each trace 70 comprises a preferably substantially circular (annular ring) head portion 72 which is connected to two substantially parallel linear neck portions or legs 74, 76 and 84.

On each of 48 are also mounted or otherwise placed a plurality of solid-state light sources 90. The solid-state light sources 90 are positioned such that they establish electrical communication with each of traces 70.

Each solid-state light sources 90 comprises a packaged light-emitting diode (LED), which, when coupled to a driver (not shown), provides an LED light engine. As shown, each trace 70 respectively connects the LEDs 90 located thereon in series. However, the LEDs 90, may also be electrically connected in parallel, or in series/parallel.

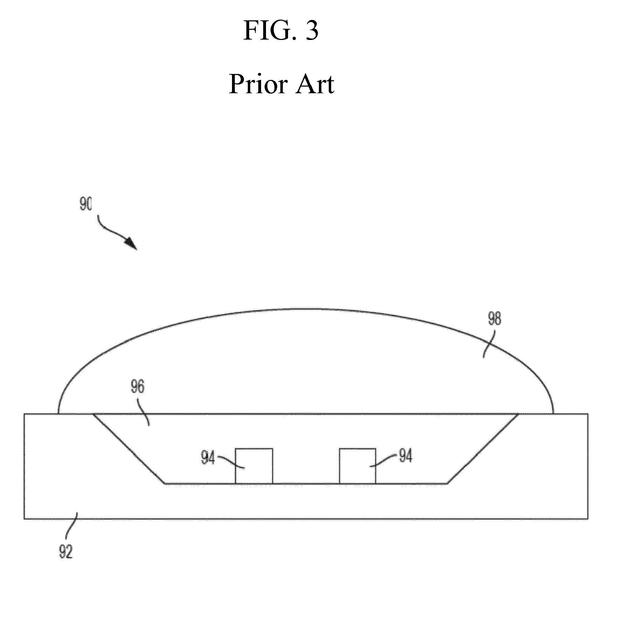

There is shown in FIG. 3 a conventional packaged light-emitting diode (LED) of the prior art which includes an LED chip 94 mounted in a substrate, such as a lead frame. As shown in FIG. 3, it is known in the art that LEDs each comprise a submount 92 on which one or more LED chips 94 are mounted. LEDs are soldered to traces 70.

As discussed in U.S. Pat. 8,998,444 (Roberts), the submount 92 may include electrical traces, wirebond pads, leads, and/or other features that permit the LED chips 94 to be mounted thereon and electrically activated. The submount 92 may also include a heat sink (not shown). An optical encapsulant 96 may surround and protect the LED chips 94 within a cavity defined in, on or by the submount 92. The encapsulant material 96 may enhance coupling of light emission out of the LED chips 94 for better extraction from the package. An optional lens 98 may be mounted on the submount 92 above the LED chips 94 to provide a desired near or far field emission pattern from the package. One or more phosphor materials can be provided within the package to convert some or all light emitted by one or more of the LED chips 94.

As shown in FIGS. 1-3, the LEDs 90 may be arranged to provide multi-directional illumination similar to that of a conventional incandescent lamp. For example, LEDs 90 may be arranged to provide light approximately 360 degrees around a longitudinal axis X-X of the lamp 10.

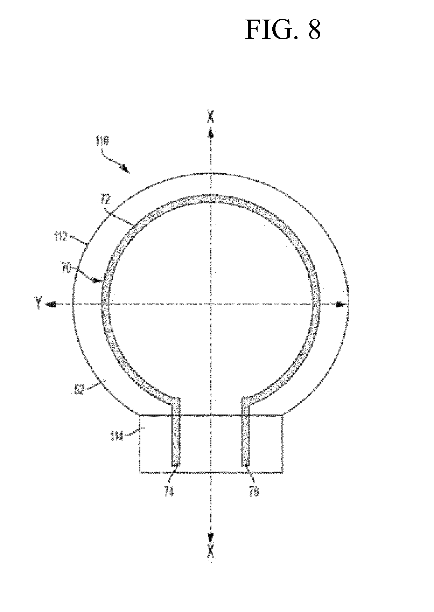

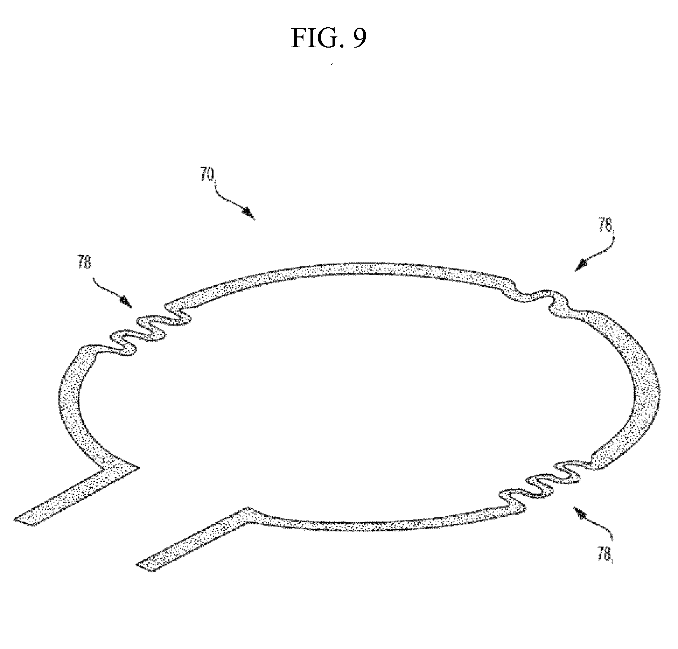

Briefly referring to FIGS. 8-9, after forming each trace 70 on the sheet segment, as well as after placing the pluralities of solid-state light sources 90 on the sheet segment 48, the sheet segment 48 may be formed into curved portions 110. More particularly, the sheet segment 48 may be formed into a curved portion 110.

The sheet segment 48 may be formed into a curved portion 110, respectively, via thermoforming, which may include vacuum forming assist or pressure forming assist.

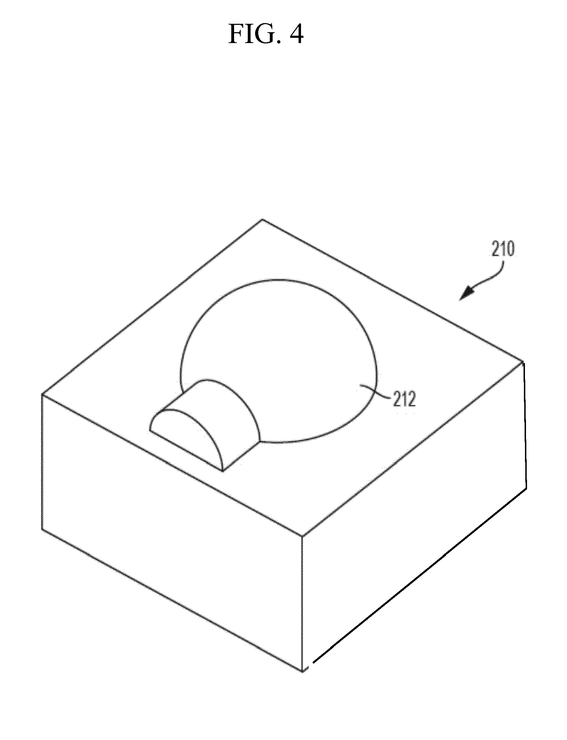

Referring now to FIGS. 4-6, in order to form sheet segment 48 into curved portion 110, the sheet segment 48 may be formed on a male forming mandrel 210 of a mold 200, which may also be understood to be a mold core. Each forming mandrel 210 has a forming surface 212 to form curved portion 110. Forming surfaces 212 are substantially duplicative of the inner surfaces 56 of the curved portion 110, as shown in FIG. 8.

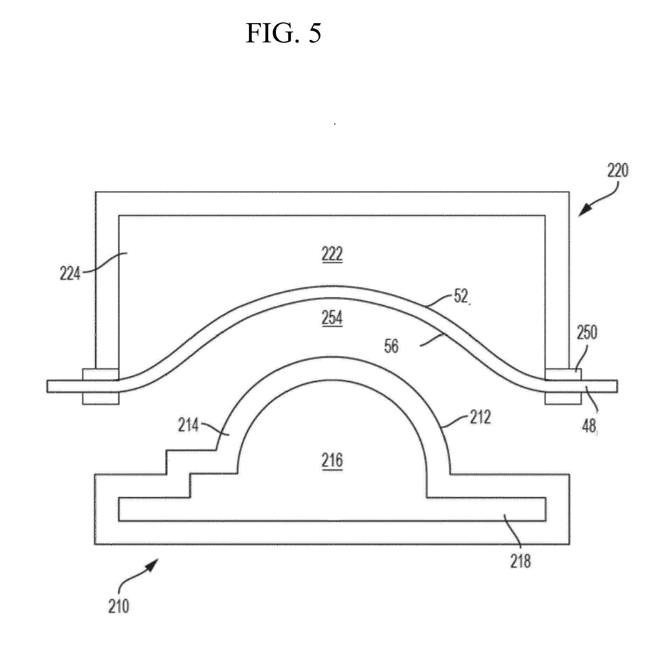

Referring more particularly to FIGS. 5-6, the mandrels 210, may comprise an air porous hollow mandrel body 214 having an internal chamber 216 therein which is coupled to a vacuum source 218. Mold 200 may further comprise a female forming box 220, which includes a forming cavity 222 coupled to a vacuum and/or pressure source 224. While not shown, it should understood that forming mandrel 230 further comprises all the components of forming mandrel 210, as well as a female pre-forming box.

In order to form curved portions 110, sheet segment 48 may be loaded into a clamping frame 250 and heated to a suitable thermoforming temperature. After heating, the clamping frame 250 may seal against a perimeter edge of the female forming box 220. Once sealed, vacuum may be applied to cavity 222 of forming box 220 from vacuum source 224, which pre-stretches the sheet segment 48 by pulling (drawing) it into cavity 222.

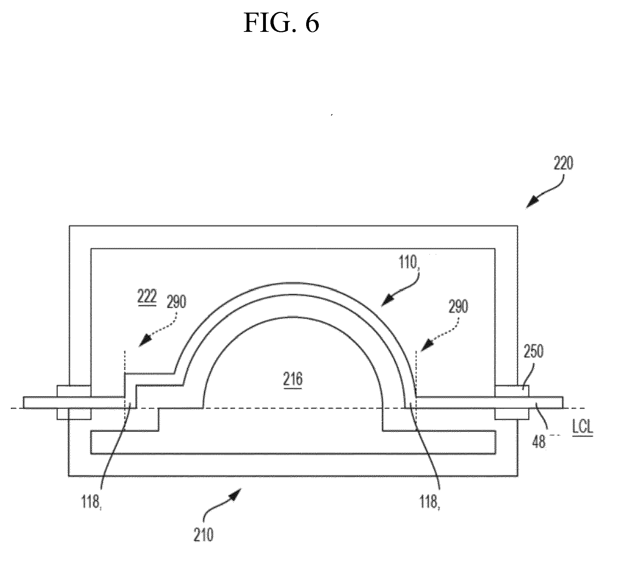

Referring to FIG. 6, when the sheet 48 has been pre-stretched to the desired pre-forming level, the male mandrel 210 enters into a recess 254 formed in the sheet 48 and seals to the clamping frame 250. Vacuum is then applied at mandrel forming surface 212 from cavity 216 and vacuum source 218, while simultaneously the cavity 222 of forming box 220 is allowed to vent to the atmosphere (or low pressure is applied in place of the vacuum from pressure source 224).

In the foregoing manner, the sheet segment 48 is formed into the curved portions 110.

With forming the curved portions 110 in the above manner, undesirable thinning of the sheet 48 at localized locations may be reduced, and the amount of stretching of the sheet 48 may be more evenly distributed throughout the whole the sheet segment 48.

Furthermore, as shown, the sheet segment 48 is orientated with the outer surfaces 52, facing cavity 222. As such, during forming, neither of the traces 70 or the LEDs 90, 110 make direct contact with a mold forming surface, which could possibly damage such. Once suitably cooled, the resultant curved portions 110 may be trimmed.

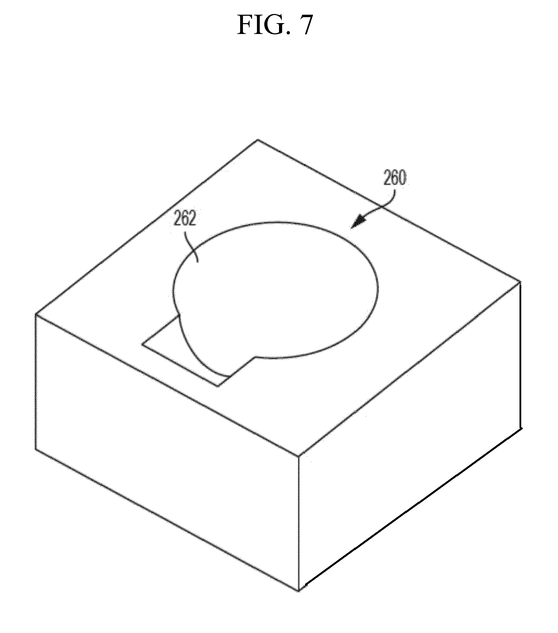

While the foregoing manufacturing method describes the use of male thermoforming, which may be vacuum and pressure assisted, female thermoforming may also be used as an alternative, to male thermoforming. Referring to FIG. 7, there is shown a female thermoforming/vacuum forming cavities 260 having cavity forming surfaces 262 which substantially duplicate outer surfaces 52 of the curved portions 110.

Female thermoforming may become more desirable if the forming surface of the female form is not found to damage either the traces 70 or the LEDs 90 when formed there against. Female thermoforming may also become more desirable if it becomes desirable to place traces 70 or the LEDs 90 on the inner surfaces 56 of the sheet segment 48 and the subsequent the curved portions 110.

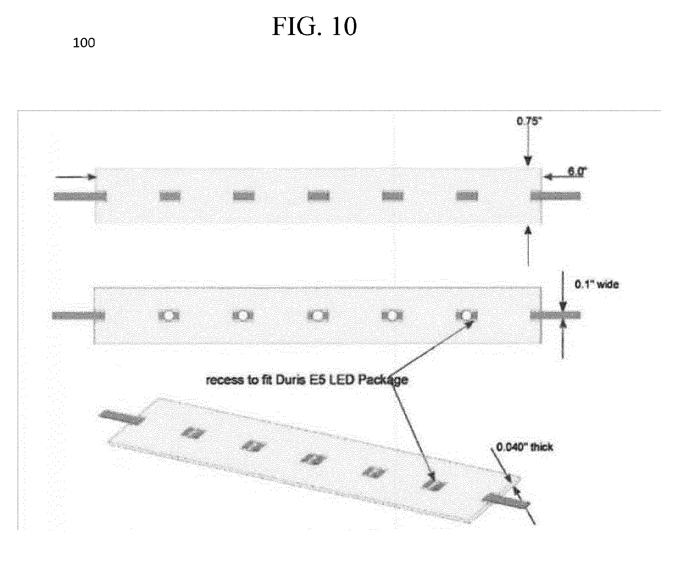

Referring now to FIGS. 8-9, there is shown an inner view (FIG. 8) and outer view (FIG. 10) of the curved portions 110 after being formed and, as appropriate, trimmed. LEDs 90 are not shown thereon for clarity. As shown, the curved portion 110 has a curved region 112 and can have a neck 114, with the annular ring 72 of trace 70 located in the curved region 112 (as well as the LEDs 90) and legs 74, 76 located on neck 114. Also as shown, curved region 112 of the curved portion 110 is permanently curved simultaneously about two axes, the longitudinal axis X and the transverse Y axis (transverse/orthogonal to the longitudinal axis X). A preferred shape creates a spherical surface and more particularly a hemi-spherical surface (referring to curved portion 110). Another example could be a hyperbolic shape which could resemble a saddle. On the other hand, neck 114 of the curved portion 110 is permanently curved only about the X axis, in a manner which creates a cylindrical surface.

Embodiments herein advantageously provide a complex, curved shape on whose surface there are points along curved regions 112 where the surface is locally curved simultaneously about two different axes that are orthogonal to one another. In contrast, for example, there are known in the art LEDs attached to flexible substrates that are curved in a cylindrical shape, such as in U.S. Pat. 6,580,228 (Chen) at figure 2, or Pat. 5,585,783 (Hall) at figure 7, but all points on those surface are curved about only one axis, not two. Likewise, other examples known in the art of an LED-bearing flexible surface that is curved about only one axis is a rectangular sheet that has been curled into a teardrop shape (as seen in cross-section) such as in U.S. Pat. 7,086,767 (Sidwell) at figure 5 or in U.S. Pat. 5,585,783 (Hall) at Fig. 6, or arched into a convex or concave bend (Hall '783 Pat. at figures 8-9).

As used herein, it should be understood that "permanently" curved means that the curved portion 110 do not return to their initial planar shape after cooling and subsequent removal from mandrels 210. However, this is not to say that the plastic material of the curved portion 110 is not reheatable as to flow again, as in the case of a thermoplastic, merely just that the shape of the mandrels 210 is retained after demolding.

During thermoforming with vacuum, or vac-forming, the sheet segment 48 may be understood to be exposed to tensile forces in the direction of draw, thus causing the sheet segment 48 to stretch/elongate and reduce in thickness in this direction, generally with the reduction in thickness being the greatest at the deepest portion of the draw of the sheet segment 48.

While it may be possible for the sheet segment 48 to undergo substantial elongation without breaking, certain materials used for each trace 70 may not exhibit such a similar elongation without breaking. For example, it may be understood that with a trace 70 which consists of metal, particularly a copper etched trace, trace 70 does not stretch/elongate in similar fashion to the sheet segment 48, and may fracture at a lower percentage of elongation.

As such, the present disclosure provides a method of manufacturing a curved component of a lamp or luminaire comprising forming at least one electrically conductive trace 70 on a sheet segment 48, wherein the sheet segment is a plastics material; placing a plurality of solid-state light sources 90 on the sheet segment 48 such that each of the solid-state light sources of the plurality of solid-state light sources 90 is in electrical communication with the at least one electrically conductive trace 70 of the sheet segment 48, wherein the plurality of solid-state light sources 90 is a plurality of light-emitting diodes, and wherein the plurality of light-emitting diodes each comprise at least one light-emitting chip 94; and forming the sheet segment 48 into a curved portion 110 after forming the at least one electrically conductive trace 70 on the sheet segment 48 and after placing the plurality of solid-state light sources 90 on the sheet segment 48, wherein the at least one electrically conductive trace 70 and the plurality of solid-state light sources 90 are located on a curved region 112 of the curved portion 110.

The curved region 112 of the curved portion 110 may be permanently curved simultaneously about two axes X, Y when forming the sheet segment 48 into the curved portion 110. Furthermore, the two axes X, Y used to form the sheet segment 48 into the curved portion 110 are orthogonal to one another. Furthermore, the curved region 112 of the curved portion 110 may include a hemi-spherical surface.

The method of manufacturing the curved component of a lamp or luminaire may further comprise at least one of heating the sheet segment 48 before forming the sheet segment 48 into the curved portion 110.

The method of manufacturing the curved component of a lamp or luminaire may further comprise at least one of cooling the curved portion 110 to retain a formed shape of the curved portion 110 after forming the sheet segment 48 into the curved portion 110.

The method of manufacturing the curved component of a lamp or luminaire may further comprise at least one of pre-stretching the sheet segment 48 with vacuum before forming the sheet segment 48 into the curved portion 110.

The method of manufacturing the curved component of a lamp or luminaire may further comprise at least one of forming the sheet segment 48 into the curved portion 110 on a male mandrel 210.

The method of manufacturing the lamp 10 may further comprise at least one of forming the sheet segment 48 into the curved portion 110 on the male mandrel 210 further includes applying vacuum through the male mandrel 210 to pull the sheet segment 48 onto a curved forming surface 212 of the male mandrel 210.

The method of manufacturing the curved component of a lamp or luminaire may further comprise at least one of: forming the sheet segment 48 into the curved portion 110 on the male mandrel 210 further includes applying positive air pressure towards the male mandrel 210 to push the sheet segment 48 onto a curved forming surface 212 of the male mandrel 210.

The development of fabrication processes to use LED packages directly attached to conductive traces contained in or on a polyester (PET) substrate for the curved component of a lamp or luminaire are described. This type of device or method may require running the LED below their rated power levels of about 0.070 ampere in order to keep the junction temperatures within the operating limits of the substrate polymer. The LED distribution may be spread out- and with the lower current the LED typically run more efficiently and there may be no requirement for an additional large passive heat sink.

The curved component of a lamp or luminaire described below can operate similarly but instead of being "flexible" it is "formable" and can be reformed multiple times if desired. The polymer can be an ABS polymer used commonly with 3D printers. Rather than screen printing or laminating conductive traces onto the ABS, the conductive traces, in this embodiment, copper ribbon can be embedded into the polymer body. The 3D printing process can deposit a layer of ... 0.010" thick per pass and if one places a conductive material between layers a circuit board of a sort can be built using the additive process of 3D printing.

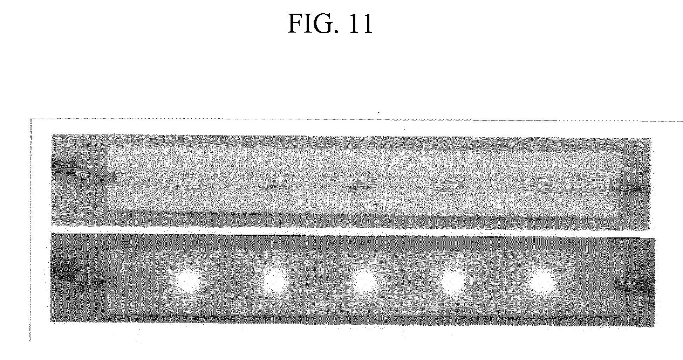

A first design 100 is modeled in Figure 10 and can be populated with Duris E5 LED's using, for example, a silver epoxy 200 as shown in Figure 11. The attachment method can be a variety of conductive epoxies or low temperature solders.

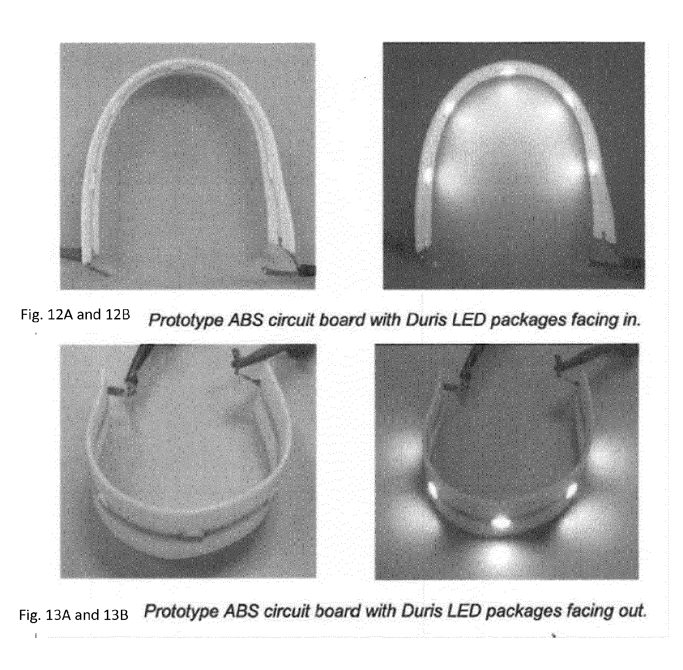

The epoxy may require curing temperature of 120C for about 15 minutes. While the sample is in the oven the ABS material becomes soft and pliable. As soon as it is removed from the oven it cools in air and returns to a rigid material which does remains slightly flexible but not formable. It can be re-heated to a temperature of about 100C and re-formed without compromising the attachment or the operation of the LED's. This is demonstrated using the lighting device 200 shown in Figure 11. Figures 12 and 13 show the two shapes that help to show the forming feature of embodiment of this invention. In the lit figure the LED can be running in series at 0.020 ampere and about 15 VDC.

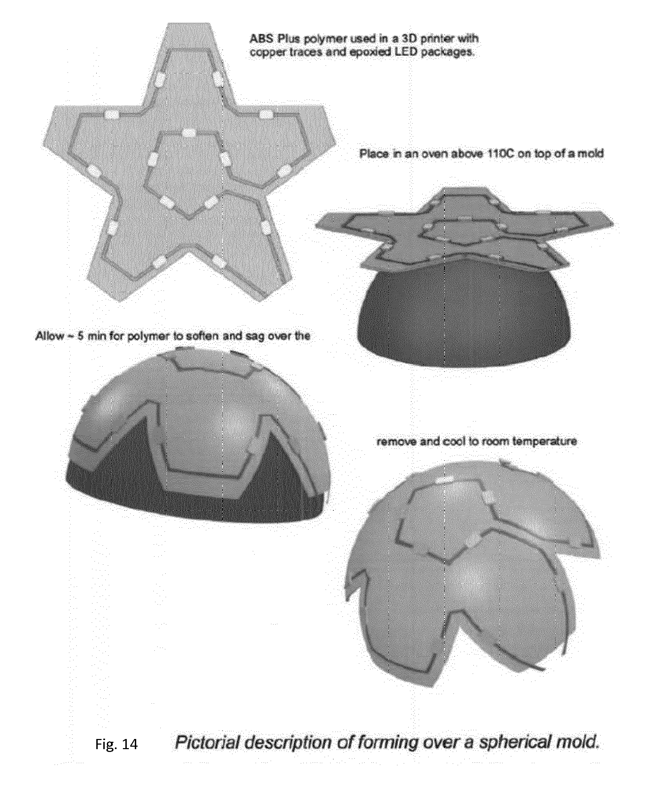

This process can be extended to form spherical type light sources as well. One such possibility was modeled simply to demonstration purposes and is shown in Figure 14. A flat piece can be printed with a circuit pattern as shown and populated with LED's. The example shown there are 15 LED's in series. This can be run at about 45 VDC, and 0.070 ampere. After the printing process is completed and the LED epoxy attachment is cured, the body can be placed over a mold that allows the ABS to sag and form around the desired form of the body.

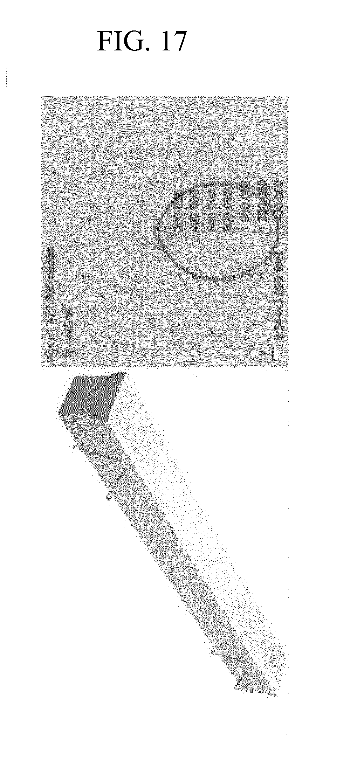

Embodiments can allow for almost any shape to be made and the re-forming feature adds more options to the end user. The following embodiments relate to a linear Solid State Lighting (SSL) luminaire based on thermally formed PET for replacement or retrofitting of linear fluorescent or standard SSL fixtures. The luminaire includes one piece integrated light engine and reflector which can be shaped through thermoforming a PET substrate, therefore controlling the desired light distribution. The current embodiment can provide a cost effective SSL luminaire replacement for the linear fixtures, either fluorescent or an alternative to standard SSL solutions. A linear luminaire can be comprised of separate components: light source (either fluorescent or LED), power supply, reflector, structural elements and other secondary optics. In most cases these fixtures have minimal optical elements to provide the required illumination levels. In most cases, although not all, the light distribution is Lambertian (I.e. symmetric) with angular cutoff at approximately 120 to 140 degrees. Typical light output from these fixtures is 4000 to 5000 lms, assuming two 32 W T8 lamps and fixture efficiency between 80% and 95%. A typical light distribution curve is shown below, Figure 17.

Embodiments of the invention can take advantage of PET substrates for LEDs in order to provide a cost effective solution for replacement of the aforementioned linear luminaires. Embodiments can include a single piece PET-based light engine (LEDs on PET with traces which can be powered by a driver) and reflector which is shaped to achieve the desired light output through thermally forming the PET sheet. This singular light engine and reflector combination can be a minimal luminaire or integrated into a traditional luminaire as a retrofit for reflector and fight source. The light output from the LEDs and formed PET can be comparable to that of a standard linear luminaire.

Linear fluorescent luminaires are ubiquitous in lighting applications such as warehouses, industry, food packaging etc. for their efficiency, low maintenance and particularly cost. They provide the necessary light with minimal optical control, typically symmetric lambertian light distributions with some angular cutoff as shown in Figure 7. They produce in the order of 5600 Lms (assuming the use of two 32 W T8 lamps) with very simple reflectors. Reflectors are typically made of a coated specular reflective material (for example Aluminum with white coating or highly reflective aluminum) and are shaped in the reflector geometry. Occasionally, but not always the case, these linear fluorescent luminaires will have a clear or transparent diffusive optic. These luminaires are all powered by fluorescent ballasts.

Similarly, a typical SSL linear luminaire is made up of LED chips on a linear metal core or FR4 PCB, which is then placed inside the luminaire as the light engine. These may be powered by a driver. Due to pixilation effects they typically have secondary optics (lenses, diffusers or louvers) in order to minimize glare and provide the necessary optical control. Other options are LED retrofit fluorescent tubes which may go into standard fluorescent fixtures. The light distributions show similar characteristics as the linear fluorescent fixtures i.e. symmetric or Lambertian. A sample LED linear fixture with its corresponding light distribution is shown in Figure 17.

Embodiments of the invention can make use of the thermoforming characteristics of PET in order to create an integrated luminaire. One advantage of using this approach can be having a single piece light engine and reflector. This can simplify the number of luminaire components and, provided it complies with the necessary regulatory requirements, the formed LED array and reflector can be the luminaire itself. This reduces the need for additional parts as well as the total cost of the bill of material. Secondly, thermally forming the PET can allow for changing the reflector geometry and as a consequence the light distribution in a single process. One advantage of this approach may be that optical systems can be optimized for the given reflector geometry as opposed to relying on correct alignment later in the construction of the luminaire. Furthermore, less standard reflectors design can be readily made and tested just by changing the mold in the thermoforming process. The optical characteristics of PET can allow for efficiencies in the order of 90%. Additionally, the relative cost of using PET as substrate for LEDs can be lower than metal core boards or FR4, which would provide a basis for a low cost solution. Furthermore, there may be a possibility (not yet tested) of creating a roll to roll process for this invention in which a sheet with printed traces is populated with LEDs, which is then thermally formed and cut to the desired size.

Embodiments of the invention can be made in the following manner. A linear array of LEDs can be placed in the middle of the substrate with additional material to either side. This sheet with populated LEDs can then go through a thermoforming process in order to give it the desired reflector shape.

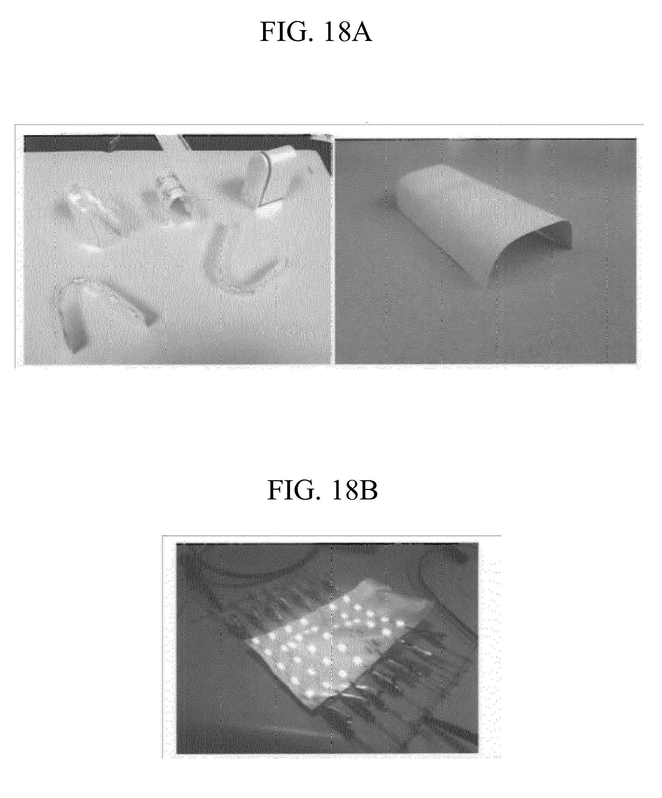

Thermally forming PET allows for creating shapes, volumes and forms which can be applied for optical use. Additionally, thermoforming also provides rigidity to the PET sheet. The potential to thermally form the PET based substrates can allow thermoforming without traces, with traces and/or with LEDs on board, Figure 18A. The traces retain continuity post-thermoforming as shown in a running thermally formed board, Figure 18B. The thickness of the PET material shown below ranges between 0.15mm and 0.30 mm.

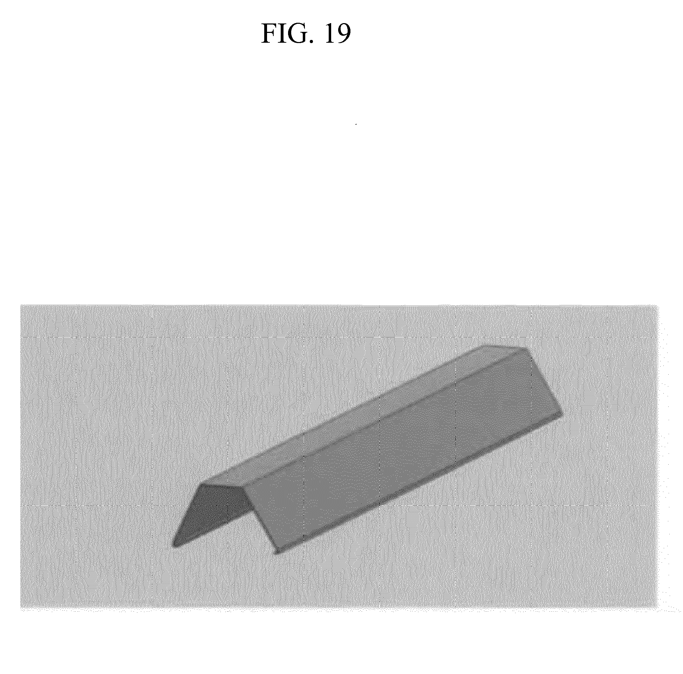

In order to obtain the desired light distribution, the additional PET material to the sides of the LED arrays could be shaped in different reflector configurations. An embodiment is shown below in a CAD model shown Figure 19. The thermoformed PET can be form a reflector in order to create the appropriate light distribution for the desired application. In most cases a Lambertian or symmetric distribution may be sufficient, however if a more engineered distribution is desired (e.g. batwing) the reflector can be shaped in the form of a parabola or more advance optical patterns. Considering the reflectivity of white PET is approximately 94% to 95% over the visible spectrum, it can be possible to obtain reasonable optical efficiency from these reflectors. As previously mentioned, initial measurements and simulations indicated optical efficiencies of up to 90%. Upon forming the reflector, the integrated light engine and reflector can either be mounted within an existing luminaire as a retrofit or used by itself as the luminaire itself.

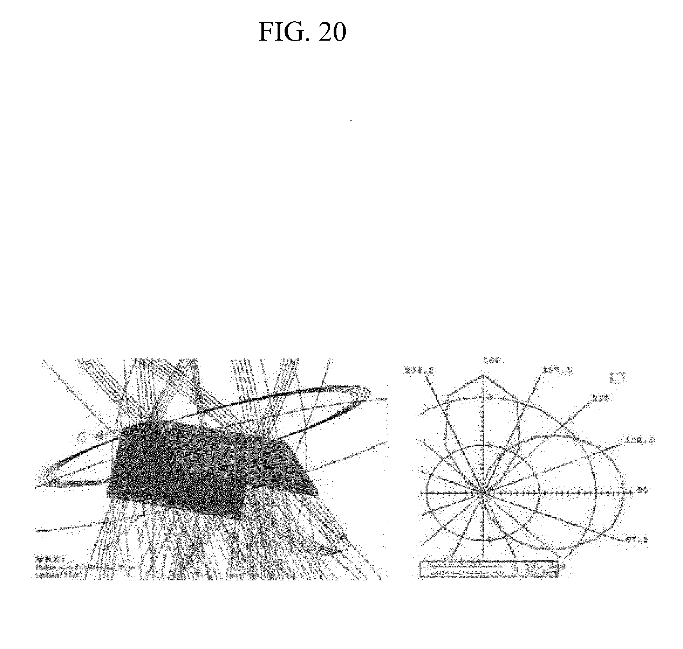

A ray tracing simulation, Figure 20, of the exemplary embodiment configuration in Figure 19 is shown. This embodiment can make use of a trapezoidal shaped reflector with four continuous linear light sources used to approximate LED linear modules, for the simulation. The reflector provides a 4 inch length on the top, with the diagonals 6 inch in length angled at 60 degrees with respect to the horizontal. The total length is 24". The light sources in the simulation are of comparable dimensions to linear LED modules (about 2 mm width, 1 mm height).

The optical characteristics of the materials modeled in the simulation were specified to match approximately those of the PET material. The angular intensity distribution, right side of Figure 20, shows a symmetric distribution with about 70 degree angular cutoff. Adjusting parameters such as the angle with respect to the horizontal (cutoff angle), reflector aperture, source size and position it may be possible to obtain a number of different angular intensity curves.

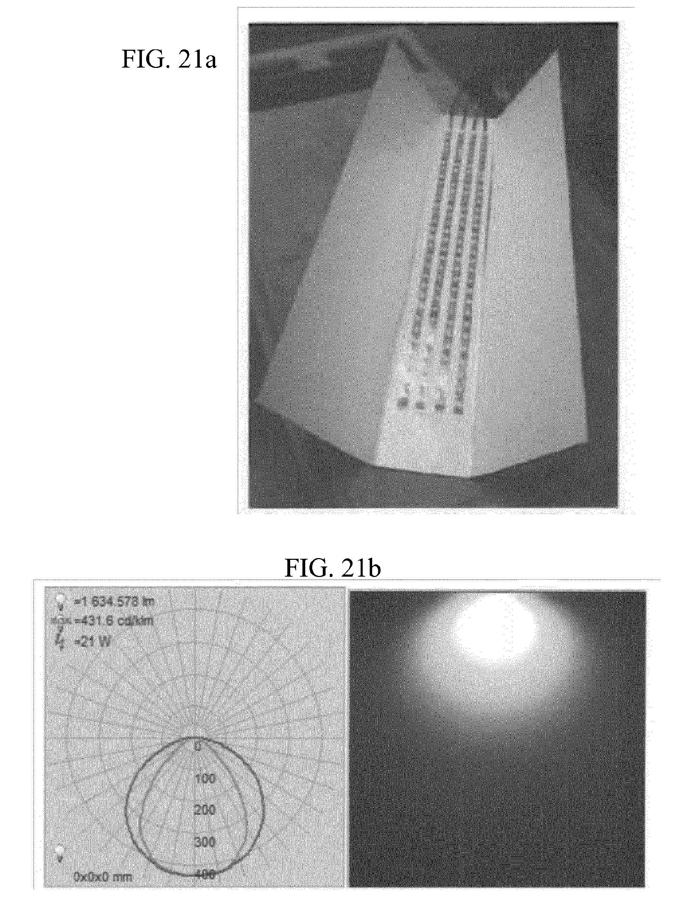

Various embodiments can be powered by an electronic driver and can be incorporated into an additional luminaire frame or assembly. In many cases, embodiments of the invention can have secondary optics (diffuser, lenses, and louvers) for additional optical control. In order to obtain initial measurements of an embodiment of the invention, a luminaire was built using an aluminum frame and lining the interior of the frame with PET material as shown in Figure 21 a. This was done to mimic the optical characteristics of a thermally formed PET reflector. The thickness of the PET is 0.15mm. The dimensions are the same as those used in the original CAD model. Four strips of LEDs were placed as light sources in order to have a comparable light source as the optical simulations.

The luminaire was measured with a near field goniometer, extrapolating the far field distribution from this data. For the measurements the LEDs were measured at 23 W (48 V; 0.48 A). The far field distribution data is shown in Figure 21b.

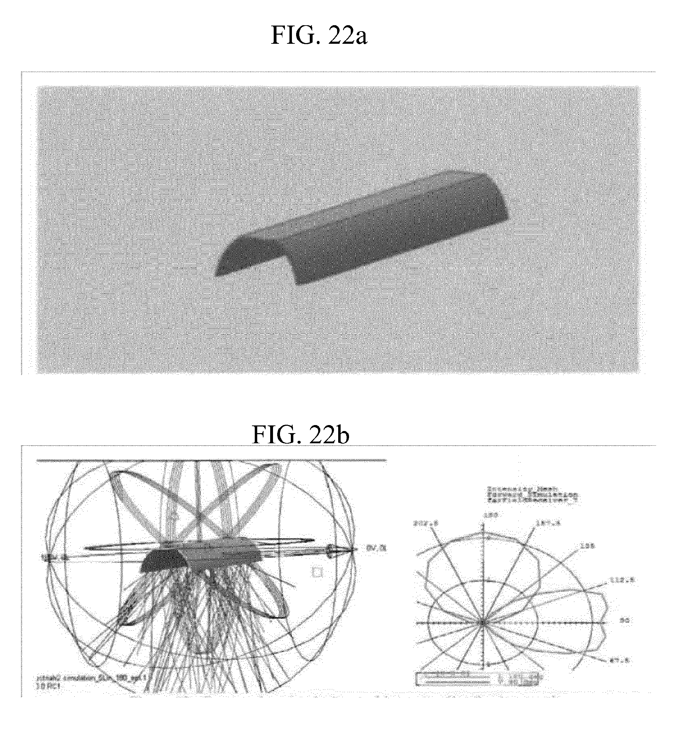

A second alterative embodiment is shown in Figure 22a. In contrast to the prior embodiment, it has a parabolic reflector. The dimensions for the model are: 4" length on the top of the luminaire, with the parabolic reflectors having a 6 inches arc length at approximately 45 degrees from the horizontal. The light source parameters and configuration are the same as in the first embodiment, with the results shown in Figure 22b. The simulated light distribution varies slightly, with a narrower beam and a slight batwing characteristic.

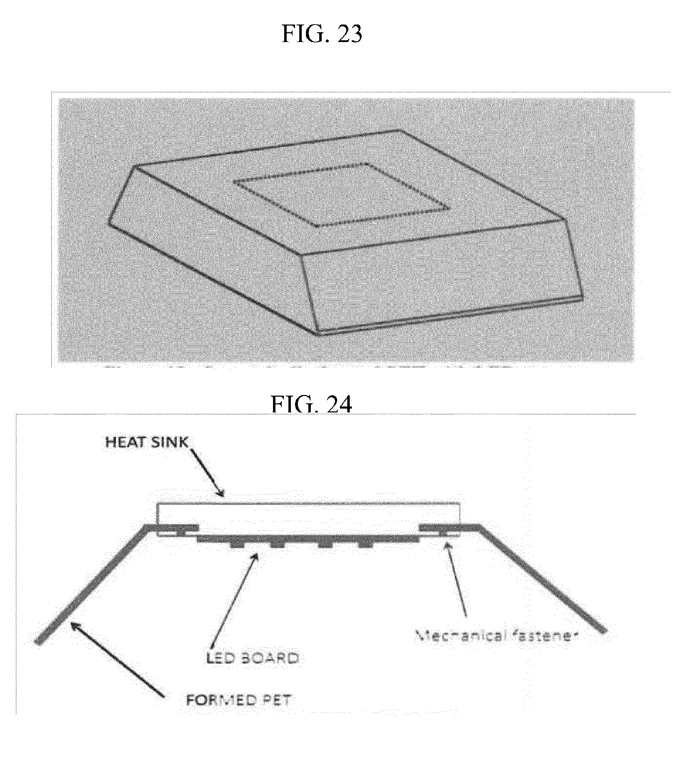

Alternative embodiments of the invention can include: changing parameters such as length, angle relative to the horizontal, reflector aperture, light source size, curvature of the reflector and other geometrical parameters will change the optical characteristics of the system. A number of these linear luminaires can be superpositioned to obtain an area light source or various beam pattern distributions. Thermoforming can not only be done in a linear way, but also in a symmetric area (e.g. a square, circle etc.). In the same way as described in other embodiments of the invention, an area array of LEDs can be placed in the middle of the PET substrate with the additional material formed around it to create an area light source. This is shown in Figure 23. This embodiment can be placed as a replacement or retrofit for 2x2 or 2x4 troffer luminaire. With the appropriate electrical circuit configuration, either the linear embodiment or the area embodiment can be used in a DC ceiling grid application and directly power the LEDs via the DC grid. Using a formed PET reflector around a standard LED board. The LED board can be placed in a heat-sink material, with slots and mechanical fasteners to insert the formed PET. One possible example is shown in Figure 24.

Embodiments of the invention an address the problem of component reduction and integration in luminaires by attempting to bring two or more components into one single piece. Additionally, embodiments may also seeks to address cost reduction of SSL luminaire replacements for fluorescent fixtures, in particular, but not limited to, linear luminaires. Embodiments may provide a low cost materials (polymer substrates) and/or processes (thermoforming) in order to achieve both stated outcomes.

Fluorescent strip and other commodity-type luminaires are ubiquitous due to their standard construction, cost ($20-$40 average retail) and relatively good light output performance. These characteristics make it attractive as a cost effective lighting solution. In its simplest form, fluorescent strip fixtures typically consist of rolled or bent sheet metal as housing and UL Class I separation, ballast and fluorescent lamps. Some may include a simple reflector to direct the upper emission from the fluorescent lamp downwards. Others may include a molded prismatic cover for additional optical control. These fixtures (assuming two T8 or T5 fluorescent lamps) have a light output between 5000 and 6000 lumens, with a Lambertian (110-120 degree) angular distribution.

Current SSL luminaires and/or retrofits may match or exceed comparable fluorescent system performance, however a drawback can be that initially they are more costly ($80 and above). Beyond the cost considerations, standard SSL luminaires are made up of separate electrical (e.g. driver, LED light engine) optical (e.g. reflectors, diffusers, lenses) and mechanical (e.g. housing) components which may require assembled post manufacturing.

Some advantage of embodiments of the invention may be the integration of luminaire component through the use of thermoformable substrates for the base of the circuit, which can then be formed to create mechanical and optical elements for the luminaire. In this particular embodiment, PET is used. By utilizing a low cost substrate, thermoformable PET, and a low cost process, thermoforming, it may be possible to achieve cost-competitive light engine/luminaire components. There may be some additional advantages to this embodiment such as reducing the overall luminaire weight, which may aid in installation and infrastructure necessary to secure the fixture.

In an exemplary embodiment, a copper circuit is attached to a sheet of thermoformable PET or other thermoplastic, with the appropriate spacing to attached LEDs to it. LEDs can be attached to the circuit of the thermoformable PET through the use of conductive epoxies or low temperature solder. The thermoformable sheet with the LEDs attached is cured according to the appropriate curing schedule. Close attention may need to be paid to the curing schedules in order to avoid deformation of the substrate. Upon finishing the curing, the circuit may be tested for electrical continuity. After testing the sheet is placed in the thermoforming (vacuum forming) equipment. The sheet is reheated until it reaches the plastic forming state and subsequently formed with the mold shape desired. The formed sheet is allowed to cool down and detached from the mold. Excess material may then be cut off. Electrical leads can be connected to the circuit and the formed luminaire can be powered to confirm electrical continuity.

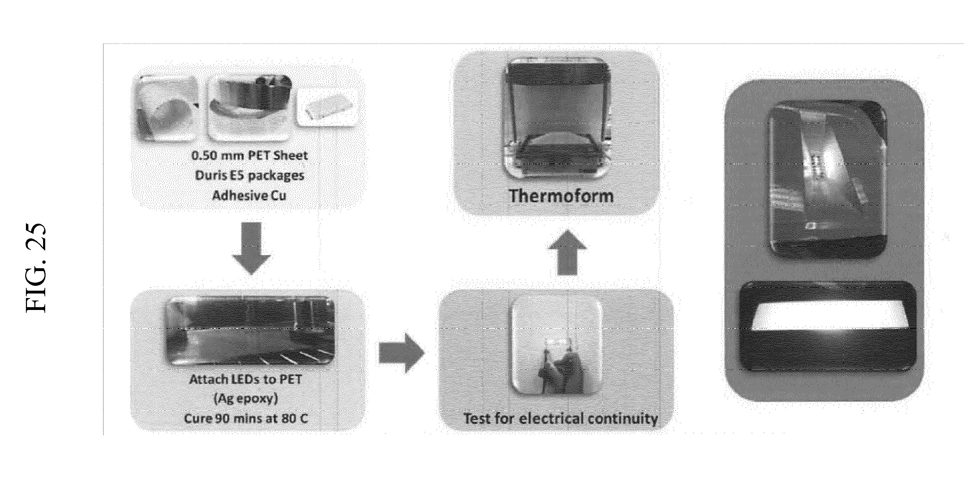

An exemplary embodiment has been made according to the description above and the process is shown visually in Figure 25. A 20 MIL PET sheet was used as a base substrate and adhesive copper ribbon was used to create the electrical circuit. A total of six Osram Duris E5 LED packages are attached to the PET sheet and circuit using silver conductive epoxy (124-0BLVC) by Creative Materials. The PET sheet, circuit and LEDs are placed in an environmental chamber to cure the epoxy for 90 minutes at 80 C. The circuit was subsequently tested for electrical continuity. The PET sheet with LEDs attached to it is placed in the thermoforming equipment, for example, molding equipment provided by Centrofor. An example mold is 17.4" (441 mm) in length, 3.7" (93.3 mm) in width and 2.66" (67.5 mm) in height. The sheet was heated up on the order of 30 seconds, lowered on to the mold, the vacuum is activated and the sheet is formed. The result is shown on the right hand side of Figure 25. Electrical leads were attached to the circuit and it was powered with a DC power supply at 12 V and 0.070 A.

There may be several alternative embodiments for the invention. First, the overall shape of the formed area can be changed using different molds, changing the form factor to square, round etc. Common shape configurations may be 2' square, 2' x 4' or 1 'x4'. Secondly, the substrate for the circuit can be changed to a different material, Polystyrene or Polycarbonate for example. Changes to the base material may require selection of different epoxies and curing processes.

There may be also alternatives as to how one produces the circuit and how it is mounted on to a thermoformable substrate. The flexible light engine can serve as a basis for the light emission. In this example, a separate process can be used in order to attach the light engine to the formed reflector. Attachment alternatives may include using plastic adhesives, co-lamination of the flexible light engine to the thermoformable substrate or post-process mechanical attachment. Another possibility for producing the circuit is through screen printing of conductive traces on the substrate.

Further examples are illustrated below:

Example 1 is a method of manufacturing a lamp. The method may include forming an electrically conductive trace on a sheet segment. The sheet segment is a thermoformable plastic. The method may further include placing a plurality of solid-state light sources on the sheet segment such that each of the solid-state light sources of the plurality of solid-state light sources is in electrical communication with the electrically conductive trace. The plurality of solid-state light sources is a plurality of light-emitting diodes. The plurality of light-emitting diodes each include at least one light-emitting chip. The method may further include thermoforming the sheet segment into a curved portion after forming the electrically conductive trace and after placing the plurality of solid-state light sources on the sheet segment. The electrically conductive trace and the plurality of solid-state light sources are located on a curved region of the curved portion.

In Example 2, the subject matter of Example1 can optionally include that the curved portion provides a reflector of the light fixture.

In Example 3, the subject matter of Example 1 can optionally include that the curved portion provides the light fixture.

In Example 4, the subject matter of any one of Examples 1 to 3 can optionally include that the method prior to the action of thermoforming further includes removing excess material of the sheet segment based on the final formed shape of the curved region.

In Example 5, the subject matter of any one of Examples 1 to 4 can optionally include that the method further includes positioning the conductive trace and plurality of solid-state light sources to minimize a radius of curvature about two axes (X, Y) when forming the sheet segment into the curved portion for the location of the conductive trace and plurality of sold-state light sources.

In Example 6, the subject matter of any one of Examples 1 to 5 can optionally include that the method further includes positioning the conductive trace and plurality of solid-state light sources to correlate to the final position when forming the sheet segment into the curved portion for the location of the conductive trace and plurality of sold-state light sources.

In Example 7, the subject matter of any one of Examples 1 to 6 can optionally include that the curved portion provides a self-shape supporting.

In Example 8, the subject matter of any one of Examples 1 to 7 can optionally include that the curved region of the curved portion is permanently curved simultaneously about two axes (X, Y) when forming the sheet segment into the curved portion.

In Example 9, the subject matter of Example 8 can optionally include that the two axes (X, Y) used to form the sheet segment into the curved portion are orthogonal to one another.

In Example 10, the subject matter of any one of Examples 8 or 9 can optionally include that the curved region of the curved portion includes a hemi-spherical surface.

In Example 11, the subject matter of any one of Examples 1 to 10 can optionally include that the method further includes heating the sheet segment before forming the sheet segment into the curved portion.

In Example 12, the subject matter of Example 11 can optionally include that the method further includes cooling the curved portion to retain a formed shape of the curved portion after forming the sheet segment into the curved portion.

In Example 13, the subject matter of any one of Examples 1 to 12 can optionally include that the method further includes pre-stretching the sheet segment with vacuum before forming the sheet segment into the curved portion.

In Example 14, the subject matter of any one of Examples 1 to 13 can optionally include that the method further includes forming the sheet segment into the curved portion on a male mandrel.

In Example 15, the subject matter of Example 14 can optionally include that forming the sheet segment into the curved portion on the male mandrel further includes applying vacuum through the male mandrel to pull the sheet segment onto a curved forming surface of the male mandrel.

In Example 16, the subject matter of any one of Examples 14 or 15 can optionally include that forming the sheet segment into the curved portion on the male mandrel further includes applying positive air pressure towards the male mandrel to push the sheet segment onto a curved forming surface of the male mandrel.

In Example 17, the subject matter of any one of Examples 1 to 16 can optionally include that the electrically conductive trace is formed by etching, printing or laminating.

Example 18 is a luminaire which may include an electrically conductive trace on a sheet segment. The sheet segment is a thermoformable plastic. The luminaire may further include a power source electrically connected to the electrically conductive traces, and a plurality of solid-state light sources on the sheet segment such that each of the solid-state light sources of the plurality of solid-state light sources is in electrical communication with the electrically conductive trace. The plurality of solid-state light sources is a plurality of light-emitting diodes. The plurality of light-emitting diodes each includes at least one light-emitting chip. The sheet segment is formed into a self-shape supporting curved portion after forming the electrically conductive trace and after placing the plurality of solid-state light sources on the sheet segment. The electrically conductive trace and the plurality of solid-state light sources are located on a curved region of the curved portion.

Example 19 is a method of manufacturing a curved component of a lamp or luminaire. The method may include forming an electrically conductive trace on a sheet segment. The sheet segment is a thermoformable plastic. The method may further include placing a plurality of solid-state light sources on the sheet segment such that each of the solid-state light sources of the plurality of solid-state light sources is in electrical communication with the electrically conductive trace. The plurality of solid-state light sources is a plurality of light-emitting diodes. The plurality of light-emitting diodes each include at least one light-emitting chip. The method may further include thermoforming the sheet segment into a self-shape supporting curved portion after forming the electrically conductive trace and after placing the plurality of solid-state light sources on the sheet segment. The electrically conductive trace and the plurality of solid-state light sources are located on a curved region of the self-shape supporting curved portion.

In Example 20, the subject matter of Example 19 can optionally include that the electrically conductive trace is formed by etching, printing or laminating.

The foregoing description of the embodiments of the invention has been presented for the purposes of illustration and description. It is not intended to be exhaustive or to limit the invention to the precise form disclosed. Many modifications and variations are possible in light of this disclosure. It is intended that the scope of the invention be limited not by this detailed description, but rather by the claims appended hereto.

While a preferred embodiment of the present disclosure has been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present disclosure. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings of the present disclosure is/are used.

Those skilled in the art will recognize, or be able to ascertain using no more than routine experimentation, many equivalents to the specific embodiments of the disclosure described herein. It is, therefore, to be understood that the foregoing embodiments are presented by way of example only and that, within the scope of the appended claims and equivalents thereto, the disclosure may be practiced otherwise than as specifically described and claimed. The present disclosure is directed to each individual feature, system, article, material, kit, and/or method described herein. In addition, any combination of two or more such features, systems, articles, materials, kits, and/or methods, if such features, systems, articles, materials, kits, and/or methods are not mutually inconsistent, is included within the scope of the present disclosure.

All definitions, as defined and used herein, should be understood to control over dictionary definitions, definitions in documents incorporated by reference, and/or ordinary meanings of the defined terms. The indefinite articles "a" and "an," as used herein in the specification and in the claims, unless clearly indicated to the contrary, are understood to mean "at least one." The phrase "and/or," as used herein in the specification and in the claims, should be understood to mean "either or both" of the elements so conjoined, i.e., elements that are conjunctively present in some cases and disjunctively present in other cases. Other elements may optionally be present other than the elements specifically identified by the "and/or" clause, whether related or unrelated to those elements specifically identified, unless clearly indicated to the contrary.

An abstract is submitted herewith. It is pointed out that this abstract is being provided to comply with the rule requiring an abstract that will allow examiners and other searchers to quickly ascertain the general subject matter of the technical disclosure. It is submitted with the understanding that it will not be used to interpret or limit the scope or meaning of the claims, as set forth in the rules of the U.S. Patent and Trademark Office.

## Claims

1. A method of manufacturing a lamp comprising:
forming an electrically conductive trace on a sheet segment, wherein the sheet segment is a thermoformable plastic;
placing a plurality of solid-state light sources on the sheet segment such that each of the solid-state light sources of the plurality of solid-state light sources is in electrical communication with the electrically conductive trace, wherein the plurality of solid-state light sources is a plurality of light-emitting diodes, and wherein the plurality of light-emitting diodes each comprise at least one light-emitting chip; and
thermoforming the sheet segment into a curved portion after forming the electrically conductive trace and after placing the plurality of solid-state light sources on the sheet segment, wherein the electrically conductive trace and the plurality of solid-state light sources are located on a curved region of the curved portion.

2. The method of claim 1 wherein:
the curved portion provides a reflector of the light fixture; or
the curved portion provides the light fixture.

3. The method of any one of claims 1 or 2 prior to the action of thermoforming further comprising:
removing excess material of the sheet segment based on the final formed shape of the curved region.

4. The method of any one of claims 1 to 3 further comprising:
positioning the conductive trace and plurality of solid-state light sources to minimize a radius of curvature about two axes (X, Y) when forming the sheet segment into the curved portion for the location of the conductive trace and plurality of sold-state light sources.

5. The method of any one of claims 1 to 4 further comprising:
positioning the conductive trace and plurality of solid-state light sources to correlate to the final position when forming the sheet segment into the curved portion for the location of the conductive trace and plurality of sold-state light sources.

6. The method of any one of claims 1 to 5 wherein:
the curved portion provides a self-shape supporting.

7. The method of any one of claims 1 to 6
wherein the curved region of the curved portion is permanently curved simultaneously about two axes (X, Y) when forming the sheet segment into the curved portion;
wherein preferably the two axes (X, Y) used to form the sheet segment into the curved portion are orthogonal to one another.

8. The method of claim 7 wherein:
the curved region of the curved portion comprises a hemi-spherical surface.

9. The method of any one of claims 1 to 8 further comprising:
heating the sheet segment before forming the sheet segment into the curved portion;
the method preferably further comprising cooling the curved portion to retain a formed shape of the curved portion after forming the sheet segment into the curved portion.

10. The method of any one of claims 1 to 9 further comprising:
pre-stretching the sheet segment with vacuum before forming the sheet segment into the curved portion.

11. The method of any one of claims 1 to 10 further comprising:
forming the sheet segment into the curved portion on a male mandrel.

12. The method of claim 11 wherein:
forming the sheet segment into the curved portion on the male mandrel further includes applying vacuum through the male mandrel to pull the sheet segment onto a curved forming surface of the male mandrel.

13. The method of claim 11 or 12 wherein:
forming the sheet segment into the curved portion on the male mandrel further includes applying positive air pressure towards the male mandrel to push the sheet segment onto a curved forming surface of the male mandrel.

14. The method of any one of claims 1 to 13 wherein:
the electrically conductive trace is formed by etching, printing or laminating.

15. A luminaire consisting essentially of:
an electrically conductive trace on a sheet segment, wherein the sheet segment is a thermoformable plastic;
a power source electrically connected to the electrically conductive traces
a plurality of solid-state light sources on the sheet segment such that each of the solid-state light sources of the plurality of solid-state light sources is in electrical communication with the electrically conductive trace, wherein the plurality of solid-state light sources is a plurality of light-emitting diodes, and wherein the plurality of light-emitting diodes each comprise at least one light-emitting chip; and
the sheet segment is formed into a self-shape supporting curved portion after forming the electrically conductive trace and after placing the plurality of solid-state light sources on the sheet segment, wherein the electrically conductive trace and the plurality of solid-state light sources are located on a curved region of the curved portion.
